# EUROPEAN PATENT SPECIFICATION

(11) **EP 2 333 807 B1**
(45) Date of publication and mention of the grant of the patent: **21.06.2023**
(21) Application number: 10275127.8
(22) Date of filing: 14.12.2010
(51) Int. Cl.: H01J 27/02, H01J 37/24

(54) **Ion beam source**
Ionstrahlenquelle
Source de faisceau ionique

(30) Priority: 14.12.2009 GB 0921791
(43) Date of publication of application: 15.06.2011
(73) Proprietor: SPP Process Technology Systems UK Limited, Newport Gwent NP18 2TA (GB)
(72) Inventor: Macneil, John, St Nicholas, Vale of Glamorgan CF5 6SH (GB); Bennet, Paul George, Bristol, BS34 8GD (GB)
(74) Representative: Wynne-Jones IP Limited

(56) References cited:
- EP-A1- 1 720 195
- EP-A2- 0 419 230
- WO-A1-01/22470
- WO-A1-2008/009898
- JP-A- H06 165 510
- US-A- 2 856 532
- US-A1- 2003 193 294
- US-B1- 6 346 768
- KORZEC D ET AL: "Bipolar extraction neutralization: Time resolved characterization", REVIEW OF SCIENTIFIC INSTRUMENTS, AIP, MELVILLE, NY, US, vol. 71, no. 2, 1 February 2000 (2000-02-01), pages 1090-1093, XP012037931, ISSN: 0034-6748, DOI: 10.1063/1.1150393
- YATSUI K ET AL: "Thin film deposition of BST by pulsed ion beam evaporation", PULSED POWER CONFERENCE, 1999. DIGEST OF TECHNICAL PAPERS. 12TH IEEE I NTERNATIONAL MONTEREY, CA, USA 27-30 JUNE 1999, PISCATAWAY, NJ, USA,IEEE, US, 27 June 1999 (1999-06-27), pages 157-160vol.1, XP032148117, DOI: 10.1109/PPC.1999.825436 ISBN: 978-0-7803-5498-2

## Description

This invention relates to an apparatus for sputtering a non-conductive material.

Ion beam deposition systems are well-suited for the deposition of metals as the conductive metal target provides an excellent electrical and thermal path avoiding any charging or thermal issues.

Such systems can be used for the deposition of insulating materials, but the target then can become quickly charged due to positive flux of ions incident on its surface. This frequently results in arcing, which typically takes place within the source.

The historical solution has been to provide a secondary source of electrons such as a hot wire, which provides thermionic emission of electrons or a plasma source such as a Kaufman cell, hollow cathode or an inductively coupled plasma.

Whilst such arrangements have been operational for some decades, there are a number of problems. In particular they each have to be installed within the vacuum system which can interfere with the ion source, target and substrate operations. The hot wire technique can create contamination, can be unreliable due to thermal expansion and contraction and can only operate in an inert vacuum ambient. The plasma sources all have cost, thermal management and potential contamination concerns.

KORZEC D ET AL: "Bipolar extraction neutralization: Time resolved characterization",REVIEW OF SCIENTIFIC INSTRUMENTS, AIP, MELVILLE, NY, US, vol. 71, no. 2, 1 February 2000 (2000-02-01), pages 1090-1093 discloses a sputtering system for insulating materials using a pulsed ion beam. The extraction grids are supplied with voltages between pulses that direct electrons from a plasma towards the target.

The invention comprises an apparatus for sputtering a non-conductive target as claimed in claim 1. An ion beam source for use with a non-electrical conducting target includes a grid for extracting ions and a power supply for supplying pulsed power to the grid to extract the ions.

The Applicants have appreciated that by pulsing the beam, the stream of positive ions to the insulating target is stopped for a short period of time. This provides sufficient time for electrons generated in the ion source and/or chamber plasma to neutralise sufficiently, and have substantially discharge, the target. "Substantially discharged" for the purposes of this specification is the discharge necessary to allow the target to function over the sputter period without arcing. Provided there is sufficient potential difference between the ions leaving the source and the target for practical operation, some charge build-up on the target can be accepted.

The power supply includes a DC supply, a power switch for connecting and interrupting supply of power to the grid and a pulse generator for switching the power switch between the DC supply voltage and ground.

The circuit may include a first FET connected between a DC supply voltage rail and a midpoint, a second FET connected between the midpoint and ground, a pair of diodes connected with each other and in parallel with the respective FET, an inductor connected to the midpoint and to a capacitance associated with the grid and a pulse generator for turning on the FETs alternately, whereby the circuit will substantially retain the grid and rail voltage when an FET is switched on and collapse the grid to ground when the FETs are switched off.

A detector for detecting an arc-generated current surge and for generating a temporary inhibit signal to maintain temporarily the grid at ground may be provided.

The detector may detect the change in the current and/or the rate of change in voltage in the grid supply and compare it with the reference or references. The detector may be in the form of a transformer.

Additionally, an embodiment of the invention includes a half-bridge DC power source having an output including a first FET for connection between a DC supply voltage rail and a midpoint, a second FET connected between the midpoint and ground, a pair of diodes connected in series and in parallel with their respective FET, an inductor connected to the midpoint and to a capacitance associated with the output and the pulse generator for turning on the FETs alternately, whereby the circuit will substantially retain the output at rail voltage when an FET is switched on and collapse the output to ground voltage when the FETs are switched off.

The source may further include a detector for detecting a current surge at the output and for generating a temporary inhibit signal to maintain temporarily the output at ground. The detector may detect the change of current and/or the rate of change voltage at the output and compare it with a reference or references. The detector may include a transformer.

The invention may be performed in various ways and specific embodiments will now be disclosed, by way of example, with reference to the accompanying drawings, in which:
Figure 1 is a perspective view of a test rig;
Figure 2 is a partially cut-away view of the rig of Figure 1;
Figure 3 is a plot of SiO2 film thickness in A (Y axis) vs position on Si wafer (X axis) using the rig of Figures 1 and 2;
Figure 4 is a corresponding plot of refractive index of the n of the SiO2 film (Y axis) vs opposition on Si wafer (X axis);
Figure 5 is a schematic view of a pulsed power source for use with an ion beam source;
Figure 6 is a detailed circuit of an alternative form of power source;
Figure 7 is a test plot for current and voltage for the source of Figure 6;
Figure 8 illustrates a block diagram of the an ion beam pulser.circuit.
Figure 9 is a circuit of a half bridge configured as a voltage stress equaliser.

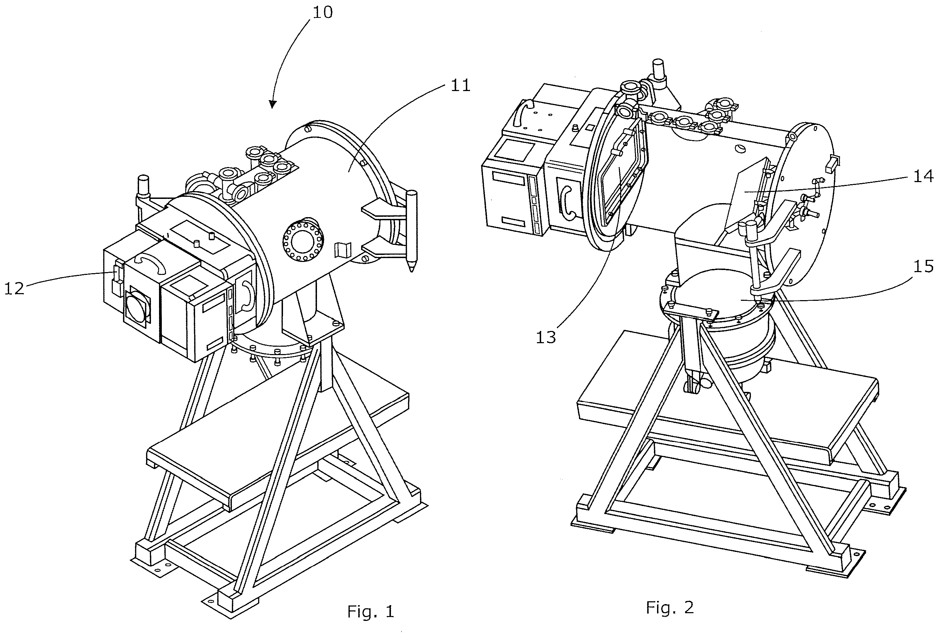

In figures 1 and 2 a test rig generally indicated at 10 includes a vacuum chamber 11 and an ion source 12. The ion source 12 is, in this case, a broad beam ion source which emits a beam of ions from the grid 13 to a tilted target 14 causing target material to be deposited on a wafer (not shown) at top of chamber 11. The ion source is of the type described in WO-A-2008/009898. In that construction the accelerator grid 13 is formed by four individual grids, one of which is maintained at a positive voltage to act as a source of ions, whilst the other grids are maintained at a negative voltage or ground in order to project the generated ions at a beam.

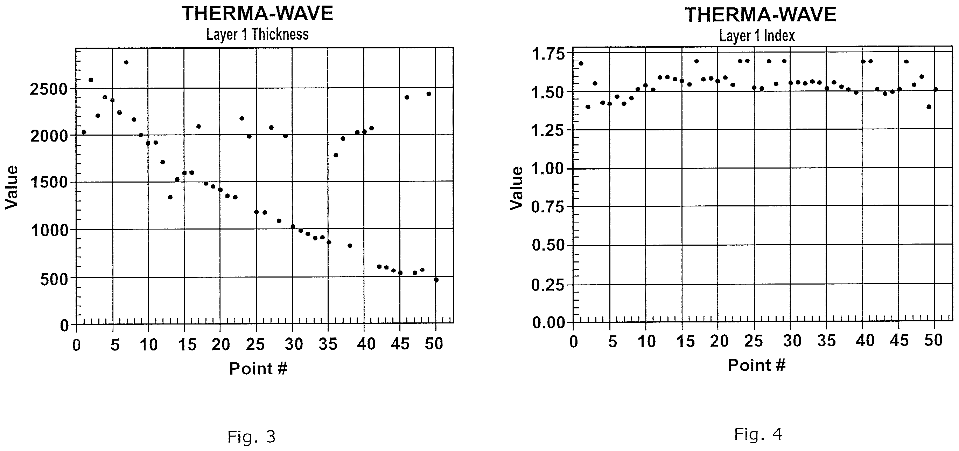

Figure 3 illustrates the thickness in A of the SiO2 layer deposited across on Si wafer using the apparatus with a 3mm thick insulating SiO2 target. The first point to note is that the layer has a thickness. If there had been charge build-up, the beam would have been killed by arcing almost immediately and no deposition would have occurred. The general trend shown by the points is an inclined thickness on the wafer, which corresponds with the inclination of the target. The high points, which do not follow the general reduction in thickness travel across the wafer are due to dust. This is believed to be due to the fact that the prototype equipment was situated in a "duty" area and not in a "clear" room . In Figure 4, the refractive index across the wafer is shown and this is fairly consistently around 1.5 which is appropriate for the film deposited. These results therefore show that a pulsed ion beam is usable with an insulating target for deposition of that target material, without the need for any secondary source of electrons.

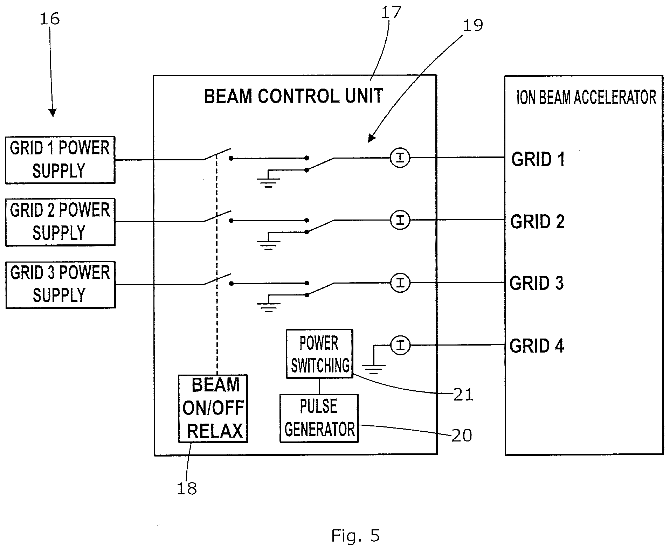

Figure 5 illustrates a schematic layout for a suitable power supply. The grids marked GRD1, GRD2, GRD3 and GRD4 correspond to the grids mentioned above. Respective power supplies generally indicated at 16 are connected to each of GRD 1 to 3, whilst GRD 4 is earthed. In the beam control unit 17 a relay 18 is provided for disconnecting all the power supplies.

A further set of switches is shown at 19 are switched between earth and the power supply rail voltage in response to a pulse generator 20 which controls a power switching arrangement 21.

With the ion source 11 under consideration, the design of the power switching has to be carefully considered because it needs to be able to handle up to 1600 volts.

Thus, ions are initially generated in an inductively coupled plasma. The grids extract the ions and columnate them into a beam. The first grid (GRD1) extracts the ions by floating the grid and inductively coupled plasma assembly up to 1600 volts positive with respect to ground. The ions therefore see a negative potential to pull them through the grid. The next two grids (GRD2 and GRD3) are biased negative with respect to ground to further pull the ions through. The final grid (GRD4) is grounded. All the beam power comes from the first grid supply which can provide up to 0.5 amps or more. At the typical maximum GRD1 voltage of 1600 volts, GRD2 and GRD3 are biased at -350 and -75 volts respectively. To regulate the beam to a current set point and fixed voltage, the ICP RF power is adjusted to a closed-loop control system. This measures the GRD1 current at the return of the power supply.

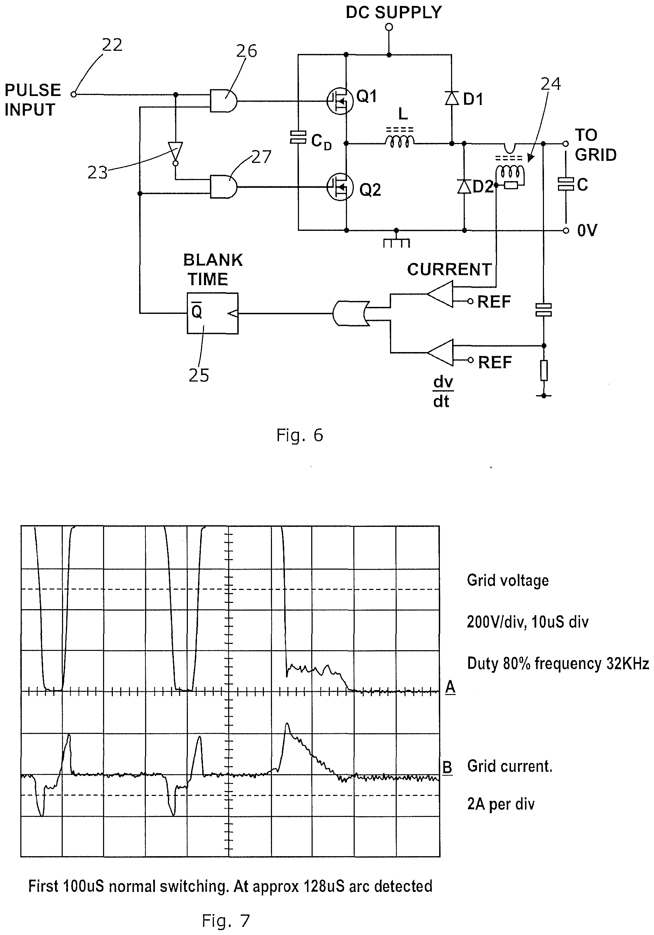

Figure 6 illustrates the basic ion beam pulser circuit for GRD1, which also includes means of arc-detection and resonant transitions. The lower voltages/powers associated with GRD2 and GRD3 could also use a resonant circuit or just limited capacitive charging with a resistor. In one arrangement GRD2 has the resonant circuit and GRD3 is a 50 ohom resistor. In figure 6 the resonance circuit is formed between an inductor L and a grid capacitance C. This enables the grid to charge and discharge efficiently without the resistive charging P = fCV² power loss.

When FET Q1 turns on the grid capacitance C is charged through inductance L. When the grid voltage grid reaches the supply voltage, resonant action with capacitance C tries to continue the voltage rise but is prevented from doing so by the diode D1. Current is therefore now trapped in the inductance L with just the voltage drop of Q1, D1 and its resistance across it. Current therefore decays only slowly, remaining close to the peak charging value. When Q1 turns off, the current can decay much more quickly forcing the junction of Q1/Q2 negative and it becomes clamped to 0 volts by the Q2 body diode. Shortly after this, Q2 is turned on. Once the current has decayed to zero, it then reverses and starts to build up again now discharging the grid capacitance. Again, a resonant transition takes place and once more current is trapped in L but now in the opposite direction clamped by Q2/D2. The cycle continues when Q2 is turned off and Q1 once again turned on.

The FETs Q1 and Q2 are switched on and off by pulses at the pulse input 22. The pulses reaching FET Q2 are out of phase to those reaching FET Q1 due to the inverter 23.

The circuit efficiently charges and discharges the grid capacitance, recycling the energy stored in inductance L. The transitions on the grid are "soft" so is electric magnetic interference and the speed requirement of D1/D2. Also current commutes in Q1 to Q2 from the same device body diode to FET (*same).* Therefore there is no forced diode recovery and switching is sufficient with low electro-magnetic interference. The penalty is the circulating current is typically in order of magnitude higher than the beam current so Q1, Q2, D1, D2 and L need to be sized for this current.

Protection is provided for both over-current and excessive dV/dt. The output current is sensed by current transformer indicated at 24. The transformer output is compared to a reference limit. If an over-current is detected a monostable 25 is triggered to give a blank period when pulsing stops. It achieves this by changing an input on each of the respective end gates 26, 27 which feed the pulses to Q1 and Q2 respectively. Both Q1 and Q2 are turned off for the duration of the blank period. Similarly if an excessive fall, e.g. negative, dV/dt is detected, a blank period will be initiated.

Typically, when an arc occurs current starts to rise. The arc current quickly escalates to an abnormally high value. When this exceeds the value stored in L, the output voltage falls and the grid capacitance is discharged. This will usually happen much faster than the normal off transitions, so it is detected by the dV/dt circuit. The action of L limits the rise of current from the circuit, so usually the system has detected the arc before over-current occurs.

When the arc is detected, Q1 is turned off so the junction of Q1/Q2 is clamped by the Q2 body diode. L then discharges through the Q2 body diode and the arc. The arc voltage is approximately constant at around 100 volts, so the current discharge is linearly in about 12µs. Energy delivered to the arc is the sum of the grid capacitance and the L stored energy. These energies are approximately equal due to the resonant action:
E = 0.5CV² + 0.5LI² and for a recognisable event: C = 3500pF, L = 500µH V=800V and I=2A. Therefore E = 1.12+1 which equals 2mJ. The energy is proportional to both current and voltage squared so at a full system voltage of 1600 volts, arc energy would be approximately 8mJ.

Such an event is illustrated in Figure 7. the GRD1 current is measured using the current transformer. This therefore does not transmit the DC levels. The actual beam current is the difference between the two settled levels between the switching transitions. This is both the positive beam on ion current and electron current when the beam is forced off. The current is approximately 0.5 amps in the scope trace.

Ion beam current regulation is achieved as normal with plasma source RF power being adjusted. Current is sensed in the DC supply. Power supply units response, output capacitance and circuit de-coupling capacitance C_{D} mean that it simply senses average current. It does not see the pulsing. Further, with a sufficiently short arc blanking time and low enough arc rate, it is not affected by arcs either. Arc blank time is set to 100µs. An arc rate of 1Hz would result in just 0.01% deposition time lost..

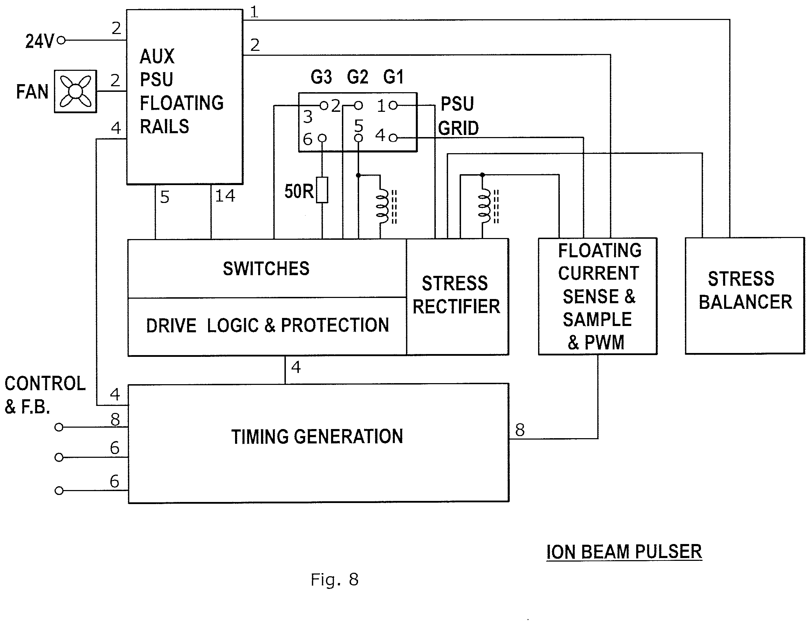

In Figure 8 which represents a block diagram of the basis components associated with constructing 19, 20 and 21 of figure 5 the supply at the top left hand corner is the 24 volt housekeeping supply which, with linear regulators, provides 15 and 5 volts for the signal electronics. A separate 15 volts is provided to perform the floating rail converter, this provides 8 floating rails for bridge drivers and the floating GRD1 current monitor. Failure indication is provided by an LED across a resistor in series with the 15 volt regulator. Switching device failure inevitably causes gates or shorts which increase the load on the converter and hence illuminate the LED. The converter itself is based on a self-oscillating half bridge driver. The transformer voltages are clamped to the 15V supply rail so that the outputs are semi regulated. Secondaries are half wave rectified. Four outputs are phased opposite to the other four to give an approximately symmetrical load. In the centre are the bridges, drivers and protection logic. The grids are also illustrated. For protection, GRD1 current is sensed by a 500:1 current transformer. A basic timing function is provided by an 8MHz quartz clock module from which various basic clock frequencies can be derived.

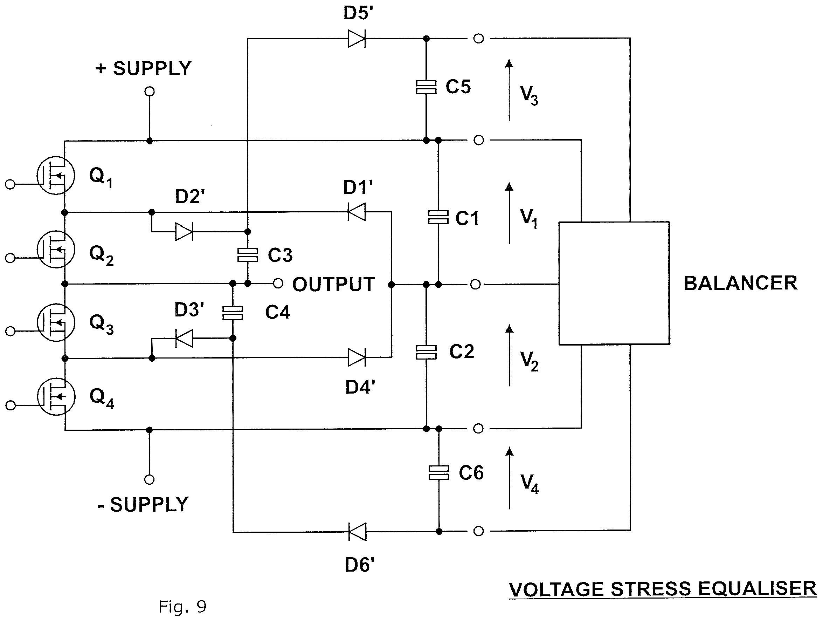

To achieve stable operation at above 1200V, the standard breakdown limit for most power devices, the circuit employs a voltage stress balancer for series connected power transistors as can be seen in Figure 9 where a half bridge incorporating 2 series connected devices (example FETs). Q1 - Q4 form the half bridge with two transistors Q1/2 and Q3/4 in each "switch position". So Q1/2 are on together and Q3/4 are on together. Detail of the balancer is not shown, it just maintains V1=V2 =V3 =V4 cycling charge between C1, 2, 5 and 6 as necessary.

If when Q1/2 are off the voltage across Q1 exceeds half the supply voltage then D1' will conduct directing charge into C1 therefore limiting the voltage across Q1 to half the supply rail. Similarly for Q4 via D4 into C2 for the lower half of the bridge. If when Q1/2 are off the voltage across Q2 exceeds half the supply voltage, the voltage across C3 will rise above half the supply voltage. When O1 and Q2 are next on, the voltage across C3 is then transferred from C3 via D5 into C5. As C5 is held at half the supply voltage, therefore so will the voltage across C3 and hence the voltage across Q2 when off. D3', C4, D6' and C6 perform the complementary function to protect Q3.

The output of the bridge maybe a square wave, pulse wave modulation (PWM) waveform or other waveform where O1/2 and Q3/4 alternately switch fully on or off. Balancing currents/energies are typically small compared to the main power through put, so relatively small and cheap components can be applied.

## Claims

1. An apparatus for sputtering a non-conductive material including:
a non-electrically conductive target; and
an ion beam source, wherein the ion beam source includes an accelerator grid for extracting ions comprising four individual grids, a first grid (GRD1) at a positive voltage with respect to a ground for extracting ions and pulling the ions through the grid, second and third grids (GRD2,GRD3) biased negative with respect to the ground to further pull the ions through the grid, and a fourth grid (GRD4) which is grounded, the source further including a DC power supply circuit for supplying pulsed power to the first, second and third grids to extract the ions, the DC power supply circuit comprising a power switch for switching the first, second and third grids between a DC supply voltage and ground, and a pulse generator for switching the power switch, the DC power supply circuit being configured to supply pulses of a duration to allow the target to be substantially discharged when the pulse is off and the first, second and third grid is connected to ground.

2. An apparatus for sputtering as claimed in Claim 1 wherein the circuit includes a first FET connected between a DC supply voltage rail and a midpoint, a second FET connected between the midpoint and ground, a pair of diodes connected in series and in parallel with a respective FET, an inductor connected to the midpoint and to a capacitance associated with the grid and a pulse generator for turning on the FETs alternately, whereby the circuit will substantially retain the first grid at rail voltage when an FET is switched on and collapse the grid to ground voltage when the FETs are switched off.

3. An apparatus for sputtering as claimed in any one of the preceding claims further including a detector for detecting an arc generated current surge and for generating a temporary inhibit signal to maintain temporarily the first grid at ground.

4. An apparatus for sputtering as claimed in Claim 3 wherein the detector is arranged to detect the rate of change current and/or voltage in the grid supply and compares it with a reference or references.

5. An apparatus for sputtering as claimed in Claim 4 wherein the detector includes a transformer.

6. An apparatus for sputtering as claimed in claim 1 including a power supply for each grid, the power supplies being controlled by a common pulse generator.

7. An apparatus for sputtering as claimed in any preceding claim wherein the power supply comprises a half bridge DC power source having an output including a first FET for connection between a DC supply voltage rail and a midpoint, a second FET connected between the midpoint and ground, a pair of diodes connected in series and in parallel with a respective FET, an inductor connected to the midpoint and to a capacitance associated with the output and a pulse generator for turning on the FETs alternately, whereby the circuit will substantially retain the output at rail voltage when an FET is switched on and collapse the output to ground voltage when the FETs are switched off.

8. An apparatus for sputtering as claimed in any preceding claim wherein the power supply comprises a half bridge DC power source having an output including a first pair of FETs for connection between a DC supply voltage rail and a midpoint, a second pair of FETs connected between the midpoint and ground, a pair of diodes connected in series and in parallel with a respective FET pair, an inductor connected to the midpoint and to a capacitance associated with the output and a pulse generator for turning on each pair of FETs alternately, whereby the circuit will substantially retain the output at rail voltage when an FET pair is switched on and collapse the output to ground voltage when the FET pairs are switched off;
and wherein the circuit further includes a voltage balancer for maintaining a cascade of stable voltage points for holding the voltage drop across each FET when off to a predetermined value by allowing excess voltage to charge an associated capacitor and allowing the capacitor to discharge when the respective FET pair is subsequently on.

9. An apparatus as claimed in claim 7 or 8 further including a detector for detecting a current surge at the output and for generating a temporary inhibit signal to maintain temporarily the output at ground.

10. An apparatus as claimed in Claim 9 wherein the detector is arranged to detect the rate of change current and/or voltage at the output and compare it with a reference or references.

11. An apparatus for sputtering as claimed in Claim 10 wherein the detector includes a transformer.

## Patentansprüche

1. Vorrichtung zum Sputtern eines nicht leitfähigen Materials, einschließlich:
eines nicht elektrisch leitfähigen Ziels; und
einer lonenstrahlquelle, wobei die lonenstrahlquelle ein Beschleunigungsgitter zum Extrahieren von Ionen umfasst, umfassend vier einzelne Gitter, ein erstes Gitter (GRD1) mit einer positiven Spannung in Bezug auf eine Masse zum Extrahieren von Ionen und Ziehen der Ionen durch das Gitter, ein zweites und ein drittes Gitter (GRD2, GRD3), die in Bezug auf die Masse negativ vorgespannt sind, um die Ionen weiter durch das Gitter zu ziehen, und ein viertes Gitter (GRD4), das geerdet ist, wobei die Quelle ferner eine Gleichstromversorgungsschaltung zum Versorgen des ersten, des zweiten und des dritten Gitters mit gepulster Leistung einschließt, um die Ionen zu extrahieren, die Gleichstromversorgungsschaltung umfassend einen Leistungsschalter zum Schalten des ersten, des zweiten und des dritten Gitters zwischen einer Gleichstromversorgungsspannung und Masse, und einen Impulsgenerator zum Schalten des Leistungsschalters, wobei die Gleichstromversorgungsschaltung konfiguriert ist, um die Impulse mit einer Dauer zuzuführen, um zu ermöglichen, dass das Ziel im Wesentlichen entladen wird, wenn der Impuls ausgeschaltet ist, und das erste, zweite und dritte Gitter mit Masse verbunden ist.

2. Vorrichtung zum Sputtern nach Anspruch 1, wobei die Schaltung einen ersten FET, der zwischen einer Gleichstromversorgungsspannungsschiene und einem Mittelpunkt verbunden ist, einen zweiten FET, der zwischen dem Mittelpunkt und Masse verbunden ist, ein Paar von Dioden, die in Reihe und parallel zu einem jeweiligen FET verbunden sind, eine Drosselspule, die mit dem Mittelpunkt und mit einer Kapazität, die dem Gitter zugeordnet ist, verbunden ist, und einen Impulsgenerator zum abwechselnden Einschalten der FETs einschließt, wobei die Schaltung im Wesentlichen das erste Gitter bei der Schienenspannung beibehält, wenn ein FET eingeschaltet ist, und das Gitter auf Massespannung fallen lässt, wenn die FETs ausgeschaltet sind.

3. Vorrichtung zum Sputtern nach einem der vorstehenden Ansprüche, die ferner einen Detektor zum Erfassen eines durch einen Bogen erzeugten Stromstoßes und zum Erzeugen eines temporären Sperrsignals einschließt, um das erste Gitter an der Masse vorübergehend zu halten.

4. Vorrichtung zum Sputtern nach Anspruch 3, wobei der Detektor angeordnet ist, um die Rate von Änderungsstrom und/oder -spannung in der Gitterversorgung zu erfassen und sie mit einer Referenz oder Referenzen vergleicht.

5. Vorrichtung zum Sputtern nach Anspruch 4, wobei der Detektor einen Transformator einschließt.

6. Vorrichtung zum Sputtern nach Anspruch 1, einschließlich einer Stromversorgung für jedes Gitter, wobei die Stromversorgungen durch einen gemeinsamen Impulsgenerator gesteuert werden.

7. Vorrichtung zum Sputtern nach einem der vorstehenden Ansprüche, wobei die Stromversorgung eine Halbbrückengleichstromquelle umfasst, die einen Ausgang aufweist, der einen ersten FET zur Verbindung zwischen einer Gleichstromversorgungsspannungsschiene und einem Mittelpunkt, einen zweiten FET, der zwischen dem Mittelpunkt und Masse verbunden ist, ein Paar von Dioden, die in Reihe und parallel zu einem jeweiligen FET verbunden sind, eine Drosselspule, die mit dem Mittelpunkt und mit einer Kapazität, die dem Ausgang zugeordnet ist, verbunden ist, und einen Impulsgenerator zum abwechselnden Einschalten der FETs einschließt, wobei die Schaltung im Wesentlichen den Ausgang bei der Schienenspannung beibehält, wenn ein FET eingeschaltet ist, und den Ausgang auf Massespannung fallen lässt, wenn die FETs ausgeschaltet sind.

8. Vorrichtung zum Sputtern nach einem der vorstehenden Ansprüche, wobei die Stromversorgung eine Halbbrückenstromquelle umfasst, die einen Ausgang aufweist, der ein erstes Paar von FETS zur Verbindung zwischen einer Gleichstromversorgungsspannungsschiene und einem Mittelpunkt, ein zweites Paar von FETs, die zwischen dem Mittelpunkt und Masse verbunden sind, ein Paar von Dioden, die in Reihe und parallel zu einem jeweiligen FET-Paar verbunden sind, eine Drosselspule, die mit dem Mittelpunkt und mit einer Kapazität, die dem Ausgang zugeordnet ist, verbunden ist, und einen Impulsgenerator zum abwechselnden Einschalten jedes Paars von FETs einschließt, wobei die Schaltung im Wesentlichen den Ausgang bei der Schienenspannung beibehält, wenn ein FET-Paar eingeschaltet ist, und den Ausgang auf Massespannung fallen lässt, wenn die FET-Paare ausgeschaltet sind;
und wobei die Schaltung ferner eine Spannungsausgleichseinrichtung zum Aufrechterhalten einer Kaskade stabiler Spannungspunkte zum Halten des Spannungsabfalls über jeden FET, wenn ausgeschaltet, bei einem vorbestimmten Wert, durch Ermöglichen, dass überschüssige Spannung einen zugehörigen Kondensator lädt und Ermöglichen, dass der Kondensator entladen wird, wenn das jeweilige FET-Paar anschließend eingeschaltet ist, einschließt.

9. Vorrichtung nach Anspruch 7 oder 8, ferner einschließlich eines Detektors zum Erfassen eines Stromstoßes an dem Ausgang und zum Erzeugen eines temporären Sperrsignals, um den Ausgang vorübergehend an der Masse zu halten.

10. Vorrichtung nach Anspruch 9, wobei der Detektor angeordnet ist, um die Rate von Änderungsstrom und/oder -spannung an dem Ausgang zu erfassen und sie mit einer Referenz oder Referenzen zu vergleichen.

11. Vorrichtung zum Sputtern nach Anspruch 10, wobei der Detektor einen Transformator einschließt.

## Revendications

1. Appareil destiné à pulvériser un matériau non conducteur comprenant :
une cible non électriquement conductrice ; et
une source de faisceau ionique, dans lequel la source de faisceau ionique comporte une grille accélératrice pour extraire des ions comprenant quatre grilles individuelles, une première grille (GRD1) à une tension positive par rapport à une terre pour extraire des ions et tirer les ions à travers la grille, de deuxième et troisièmes grilles (GRD2, GRD3) polarisées négativement par rapport à la terre pour tirer davantage les ions à travers la grille, et une quatrième grille (GRD4) qui est mise à la terre, la source comportant en outre un circuit d'alimentation en courant continu pour fournir une puissance pulsée aux première, deuxième et troisième grilles pour extraire les ions, le circuit d'alimentation en courant continu comprenant un commutateur d'alimentation pour commuter les première, deuxième et troisième grilles entre une tension d'alimentation continue et la terre, et un générateur d'impulsions pour commuter le commutateur d'alimentation, le circuit d'alimentation en courant continu étant configuré pour fournir des impulsions d'une durée permettant de décharger sensiblement la cible lorsque l'impulsion est désactivée et que les première, deuxième et troisième grilles sont connectées à la terre.

2. Appareil de pulvérisation selon la revendication 1, dans lequel le circuit comporte un premier FET connecté entre un rail de tension d'alimentation continue et un point médian, un second FET connecté entre le point médian et la terre, une paire de diodes connectées en série et en parallèle avec un FET respectif, une inductance connectée au point médian et à une capacité associée à la grille et un générateur d'impulsions pour activer alternativement les FET, moyennant quoi le circuit maintient sensiblement la première grille à la tension du rail lorsqu'un FET est activé et abaisse la grille à la tension de terre lorsque les FET sont désactivés.

3. Appareil de pulvérisation selon l'une quelconque des revendications précédentes, comportant en outre un détecteur pour détecter une pointe de courant générée par un arc et pour générer un signal d'inhibition temporaire afin de maintenir temporairement la première grille à la terre.

4. Appareil de pulvérisation selon la revendication 3, dans lequel le détecteur est conçu pour détecter le taux de variation du courant et/ou de la tension dans l'alimentation du réseau et le compare à une ou plusieurs références.

5. Appareil de pulvérisation selon la revendication 4, dans lequel le détecteur comporte un transformateur.

6. Appareil de pulvérisation selon la revendication 1, comportant une alimentation pour chaque grille, les alimentations étant commandées par un générateur d'impulsions commun.

7. Appareil de pulvérisation selon l'une quelconque revendication précédente, dans lequel l'alimentation comprend une source de courant continu en demi-pont ayant une sortie comportant un premier FET pour la connexion entre un rail de tension d'alimentation en courant continu et un point médian, un second FET connecté entre le point médian et la terre, une paire de diodes connectées en série et en parallèle avec un FET respectif, une inductance connectée au point médian et à une capacité associée à la sortie et un générateur d'impulsions pour activer alternativement les FET, moyennant quoi le circuit maintient sensiblement la sortie à la tension du rail lorsqu'un FET est activé et abaisse la sortie à la tension de terre lorsque les FET sont désactivés.

8. Appareil de pulvérisation selon l'une quelconque revendication précédente, dans lequel l'alimentation comprend une source de courant continu en demi-pont ayant une sortie comportant une première paire de FET pour la connexion entre un rail de tension d'alimentation en courant continu et un point médian, une seconde paire de FET connectée entre le point médian et la terre, une paire de diodes connectées en série et en parallèle avec une paire de FET respective, une inductance connectée au point médian et à une capacité associée à la sortie et un générateur d'impulsions pour activer alternativement chaque paire de FET, moyennant quoi le circuit maintient sensiblement la sortie à la tension du rail lorsqu'une paire de FET est activée et abaisse la sortie à la tension de terre lorsque les paires de FET sont désactivées ;
et dans lequel le circuit comporte en outre un équilibreur de tension pour maintenir une cascade de points de tension stables afin de maintenir la chute de tension aux bornes de chaque FET lorsqu'il est désactivé à une valeur prédéterminée en permettant à la tension excédentaire de charger un condensateur associé et en permettant au condensateur de se décharger lorsque la paire de FET respective est ensuite activée.

9. Appareil selon la revendication 7 ou 8, comportant en outre un détecteur pour détecter une pointe de courant au niveau de la sortie et pour générer un signal d'inhibition temporaire afin de maintenir temporairement la sortie à la terre.

10. Appareil selon la revendication 9, dans lequel le détecteur est conçu pour détecter le taux de variation du courant et/ou de la tension au niveau de la sortie et le comparer à une ou plusieurs références.

11. Appareil de pulvérisation selon la revendication 10, dans lequel le détecteur comprend un transformateur.
